# EUROPEAN PATENT APPLICATION

(11) **EP 4 730 567 A1**
(43) Date of publication of application: **22.04.2026**
(21) Application number: 25208487.6
(22) Date of filing: 14.10.2025
(51) Int. Cl.: H01R 12/58, H05K 1/14, H01R 12/91, H01R 13/66, H05K 1/18, H05K 5/00, H01R 13/74

(54) **ELECTRICAL CONNECTION MODULE, CONNECTOR AND CONNECTOR ASSEMBLY**

(30) Priority: 16.10.2024 CN 202411448682
(71) Applicant: Tyco Electronics (Shanghai) Co., Ltd., Pilot Free Trade Zone Shanghai 200131 (CN)
(72) Inventor: Wang, Ke, Suzhou, 215121 (CN); Zhou, Xiao, Shanghai, 200233 (CN); Yuan, Wei, Shanghai, 200233 (CN)
(74) Representative: Grünecker Patent- und Rechtsanwälte PartG mbB

(57) **Abstract**

The present invention discloses an electrical connection module, a connector, and a connector assembly. The electrical connection module comprises: a circuit board (3), a first terminal (1) and a second terminal (2). The circuit board (3) includes: a first hard board part (31) which is formed with a first insertion hole (301); a second hard board part (32) which is formed with a second insertion hole (302); and a middle soft board part (33) which is connected between the first hard board part (31) and the second hard board part (32) and is adapted to be bent. The first terminal (1) has a first pin (1a) that is plugged into the first insertion hole (301). The second terminal (2) has a second pin (2a) inserted into the second insertion hole (302). A conductive trace is formed on the circuit board (3) to electrically connect the first insertion hole (301) and the second insertion hole (302); the first terminal (1) is adapted to be fixed to a fixed housing (4) of a connector for mating with a mating terminal of a mating connector, and the second terminal (2) is adapted to be held to a floatable housing (5) of the connector. In the present invention, the middle soft board part of the circuit board can undergo elastic deformation with the floating of the floatable housing. Therefore, the circuit board will not affect the floating performance of the floatable housing.

## Description

### CROSS-REFERENCE TO RELATED APPLICATION

This application claims the benefit of Chinese Patent Application No. CN202411448682.2 filed on October 16, 2024 in the State Intellectual Property Office of China, the whole disclosure of which is incorporated herein by reference.

### BACKGROUND OF THE INVENTION

### Field of the Invention

The present invention relates to an electrical connection module, a connector comprising the electrical connection module, and a connector assembly comprising the connector.

### Description of the Related Art

In the prior art, a connector typically includes a housing, a circuit board, multiple first terminals, multiple second terminals, and a floating seat. The circuit board is set in the housing, and one ends of the first terminal and the second terminal are plugged into the circuit board. The first terminal is fixed to the housing for mating with the mating terminal inserted into the housing. The floating seat is installed on the housing in a movable manner and can float relative to the housing. The second terminal passes through the holding hole in the floating seat for electrical connection with an external circuit board. In the prior art, the circuit board inside the connector is a single hard board that cannot undergo elastic deformation. Therefore, when the insertion and extraction force between the second terminal and the floating seat is large, it is easy to cause the floating seat to be unable to float relative to the housing.

### SUMMARY OF THE INVENTION

The present invention has been made to overcome or alleviate at least one aspect of the above mentioned disadvantages.

According to an aspect of the present invention, there is provided an electrical connection module. The electrical connection module comprises: a circuit board, a first terminal and a second terminal. The circuit board includes: a first hard board part which is formed with a first insertion hole; a second hard board part which is formed with a second insertion hole; and a middle soft board part which is connected between the first hard board part and the second hard board part and is adapted to be bent. The first terminal has a first pin that is plugged into the first insertion hole; The second terminal has a second pin inserted into the second insertion hole. A conductive trace is formed on the circuit board to electrically connect the first insertion hole and the second insertion hole; the first terminal is adapted to be fixed to a fixed housing of a connector for mating with a mating terminal of a mating connector, and the second terminal is adapted to be held to a floatable housing of the connector.

According to an exemplary embodiment of the present invention, the first pin is electrically connected to the second pin via the conductive trace on the circuit board, and the first hard board part and the second hard board part face each other when the middle soft board part is bent into a U-shape.

According to another exemplary embodiment of the present invention, the thickness of the middle soft plate part is smaller than that of the first hard plate part and the second hard plate part, so that the middle soft plate part has elasticity and can be bent into a U-shape.

According to another exemplary embodiment of the present invention, the first pin of the first terminal is fish eye shaped and press fitted into the first insertion hole in the circuit board, and the second pin of the second terminal is fish eye shaped and press fitted into the second insertion hole in the circuit board.

According to another exemplary embodiment of the present invention, multiple first insertion holes arranged in an array are formed in the first hard board part, and multiple second insertion holes arranged in an array are formed in the second hard board part; the electrical connection module comprises multiple first terminals and multiple second terminals, the first pins of the multiple first terminals are respectively plugged into the multiple first insertion holes, and the second pins of the multiple second terminals are respectively plugged into the multiple second insertion holes.

According to another exemplary embodiment of the present invention, a first locking hole adapted to engage with a first elastic buckle on the fixed housing is formed in the first hard plate part to fix the first hard plate part to the fixed housing; and/or a second locking hole suitable for engaging with a second elastic buckle on the floatable housing is formed in the second hard plate part to fix the second hard plate part to the floatable housing.

According to another aspect of the present invention, there is provided a connector. The connector comprises: a fixed housing, suitable for being fixed to an installation panel; a floatable housing which is mounted on the rear of the fixed housing in a movable manner and can float relative to the fixed housing; and the above electrical connection module. The middle soft board part of the circuit board is bent so that the first hard board part and the second hard board part face each other in the longitudinal direction of the fixed housing or form a certain angle, the first terminal is fixed to the fixed housing for mating with a mating terminal of a mating connector inserted into the fixed housing, the floatable housing is suitable for installation on an external circuit board, and the second terminal is held to the floatable housing for electrical connection with the external circuit board.

According to an exemplary embodiment of the present invention, the fixed housing comprises a front housing part and a rear housing part that are opposite in its longitudinal direction, and a partition wall that separates the inner cavities of the front housing part and the rear housing part, a first terminal hole is formed in the partition wall; the first hard plate part is accommodated in the rear housing part of the fixed housing, and the first terminal passes through the first terminal hole in the partition wall and extends into the front housing part to mate with the mating terminal inserted into the front housing part.

According to another exemplary embodiment of the present invention, the first terminal is interference fit with the first terminal hole to fix the first terminal into the fixed housing.

According to another exemplary embodiment of the present invention, a first elastic buckle is formed on the partition wall of the fixed housing, which engages with the first locking hole in the first hard plate part to lock the first hard plate part to the fixed housing.

According to another exemplary embodiment of the present invention, a first support protrusion is formed on the partition wall of the fixed housing, which is suitable for leaning against one side of the first hard plate part. The first elastic buckle comprises: a first cantilever part which is connected to the partition wall; and a first protrusion which is formed on the end of the first cantilever. The first cantilever part passes through the first locking hole, and the first protrusion and the first support protrusion respectively rest on both sides of the first hard plate part to fix the first hard plate part to the partition wall.

According to another exemplary embodiment of the present invention, the floatable housing comprises an end wall facing the second hard plate part and a peripheral wall connected to the periphery of the end wall, and a second terminal hole is formed in the end wall of the floatable housing; the second hard board part is accommodated in the floatable housing, and the second terminal extends from the floatable housing through the second terminal hole to be plugged into an insertion hole in the external circuit board.

According to another exemplary embodiment of the present invention, the second terminal is interference fit with the second terminal hole to fix the second terminal to the floatable housing.

According to another exemplary embodiment of the present invention, a second elastic buckle is formed on the end wall of the floatable housing, which engages with the second locking hole in the second hard plate part to lock the second hard plate part to the floatable housing.

According to another exemplary embodiment of the present invention, a positioning post is formed on the outer side of the end wall of the floatable housing, which is used to mate with a positioning hole in the external circuit board to guide the second terminal to be inserted into the insertion hole in the external circuit board.

According to another exemplary embodiment of the present invention, two positioning posts with different diameters are formed on the outer side of the end wall of the floatable housing, which are used to respectively mate with two positioning holes with different diameters in the external circuit board.

According to another exemplary embodiment of the present invention, the peripheral wall of the floatable housing is installed into the rear housing part of the fixed housing, and multiple elastic buckles distributed at intervals are formed on the peripheral wall of the floatable housing; multiple slots are formed on the rear housing part of the fixed housing, and the multiple elastic buckles are respectively engaged with the multiple slots in a movable manner, so that the floatable housing can float relative to the fixed housing but cannot be separated from the fixed housing.

According to another exemplary embodiment of the present invention, the elastic buckle comprises: a cantilever; and a protrusion which is formed at the end of the cantilever. The protrusion of the elastic buckle is engaged into the slot and the size of the slot is larger than the protrusion to allow the floatable housing to float relative to the fixed housing along the longitudinal direction, transverse direction, and height direction of the fixed housing.

According to another exemplary embodiment of the present invention, multiple elastic structures spaced apart are also formed on the peripheral wall of the floatable housing, and multiple support platforms are formed on the partition wall of the fixed housing; the multiple elastic structures are adapted to respectively rest on the multiple support platforms and can elastically deform along the longitudinal direction of the fixed housing, so that the floatable housing can float relative to the fixed housing in the longitudinal direction.

According to another exemplary embodiment of the present invention, the elastic structure comprises a pair of curved elastic arms, and the elastic structure is in the shape of an Ω.

According to another exemplary embodiment of the present invention, the fixed housing further comprises a flange part located outside it for fixing to an installation panel, and the connector further comprises a nut embedded in the flange part for threaded connection with a screw, so that the flange part can be fixed to the installation panel through the screw.

According to another exemplary embodiment of the present invention, the fixed housing is an integral injection molded part, and the fixed housing is directly injected onto the nut, making the fixed housing and the nut an integrated piece.

According to another exemplary embodiment of the present invention, the flange part has front and rear sides opposite to each other in the longitudinal direction of the fixed housing, and a sealing ring installation groove is formed on the front side of the flange part, the nut is located in the area surrounded by the sealing ring installation groove; the connector further comprises a sealing ring installed into the sealing ring installation groove, wherein the sealing ring is adapted to be compressed between the flange part and the installation panel to achieve sealing between the two.

According to another aspect of the present invention, there is provided a connector assembly. The connector assembly comprises: the above connector; and an external circuit board electrically connected to the second terminal of the connector. An insertion hole and a positioning hole are formed in the external circuit board, the second terminal is inserted into the insertion hole in the external circuit board, and the positioning post on the floatable housing is inserted into the positioning hole in the external circuit board.

According to an exemplary embodiment of the present invention, the connector assembly further comprises a mating connector which is mated with the connector.

In the aforementioned exemplary embodiments according to the present invention, the middle soft board part of the circuit board has elasticity, allowing the circuit board to undergo elastic deformation with the floating of the floatable housing. Therefore, the circuit board will not affect the floating performance of the floatable housing.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of an electrical connection module according to an exemplary embodiment of the present invention;
Figure 2 shows an illustrative exploded view of an electrical connection module according to an exemplary embodiment of the present invention;
Figure 3 shows an illustrative perspective view of an electrical connection module according to an exemplary embodiment of the present invention, in which the middle flexible board part of the circuit board is bent into a U-shape;
Figure 4 shows an illustrative perspective view of a connector according to an exemplary embodiment of the present invention when viewed from one side, wherein the floatable housing has not yet been installed to the fixed housing, and the middle soft board part of the circuit board has not been bent;
Figure 5 shows an illustrative exploded view of a connector according to an exemplary embodiment of the present invention when viewed from one side, wherein the floatable housing has not yet been installed to the fixed housing, and the middle soft board part of the circuit board has not been bent;
Figure 6 shows an illustrative perspective view of a connector according to an exemplary embodiment of the present invention when viewed from the other side, wherein the floatable housing has not yet been installed to the fixed housing, and the middle soft board part of the circuit board has not been bent;
Figure 7 shows an illustrative exploded view of a connector according to an exemplary embodiment of the present invention when viewed from the other side, where the floatable housing has not yet been installed to the fixed housing and the middle soft board part of the circuit board has not been bent;
Figure 8 shows an illustrative perspective view of a connector according to an exemplary embodiment of the present invention, wherein the floatable housing has been installed to the fixed housing, and the middle soft board part of the circuit board has been bent into a U-shape;
Figure 9 shows a longitudinal sectional view of a connector according to an exemplary embodiment of the present invention;
Figure 10 shows another longitudinal sectional view of a connector according to an exemplary embodiment of the present invention;
Figure 11 shows an illustrative exploded view of a connector and an external circuit board according to an exemplary embodiment of the present invention; and
Figure 12 shows an illustrative assembly view of a connector and an external circuit board according to an exemplary embodiment of the present invention.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided an electrical connection module. The electrical connection module comprises: a circuit board, a first terminal and a second terminal. The circuit board includes: a first hard board part which is formed with a first insertion hole; a second hard board part which is formed with a second insertion hole; and a middle soft board part which is connected between the first hard board part and the second hard board part and is adapted to be bent. The first terminal has a first pin that is plugged into the first insertion hole; The second terminal has a second pin inserted into the second insertion hole. A conductive trace is formed on the circuit board to electrically connect the first insertion hole and the second insertion hole; the first terminal is adapted to be fixed to a fixed housing of a connector for mating with a mating terminal of a mating connector, and the second terminal is adapted to be held to a floatable housing of the connector.

According to another general concept of the present invention, there is provided a connector. The connector comprises: a fixed housing, suitable for being fixed to an installation panel; a floatable housing which is mounted on the rear of the fixed housing in a movable manner and can float relative to the fixed housing; and the above electrical connection module. The middle soft board part of the circuit board is bent so that the first hard board part and the second hard board part face each other in the longitudinal direction of the fixed housing or form a certain angle, the first terminal is fixed to the fixed housing for mating with a mating terminal of a mating connector inserted into the fixed housing, the floatable housing is suitable for installation on an external circuit board, and the second terminal is held to the floatable housing for electrical connection with the external circuit board.

According to another general concept of the present invention, there is provided a connector assembly. The connector assembly comprises: the above connector; and an external circuit board electrically connected to the second terminal of the connector. An insertion hole and a positioning hole are formed in the external circuit board, the second terminal is inserted into the insertion hole in the external circuit board, and the positioning post on the floatable housing is inserted into the positioning hole in the external circuit board.

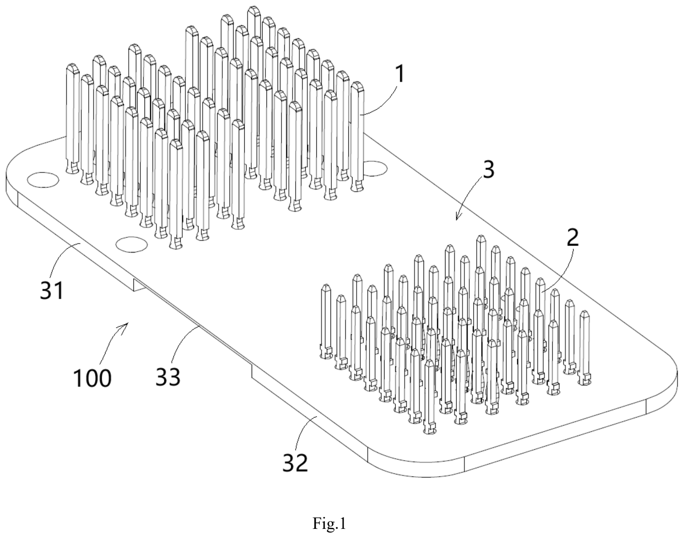

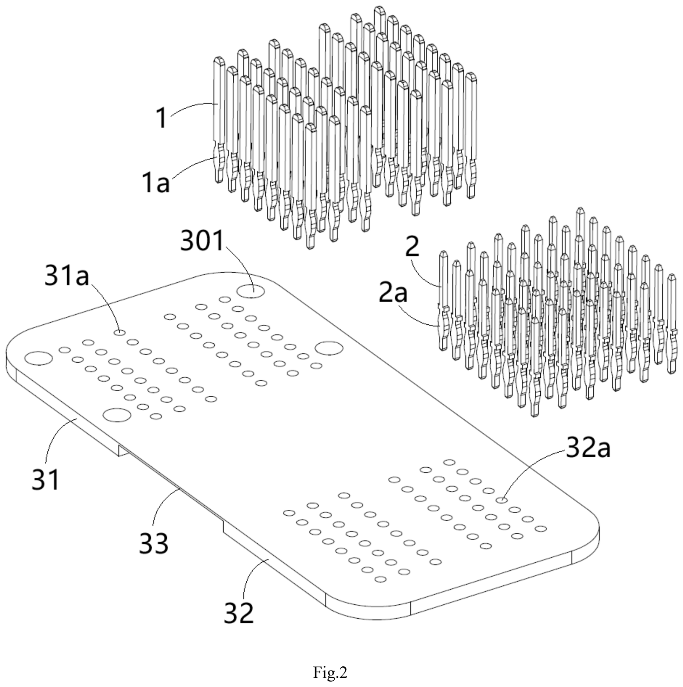

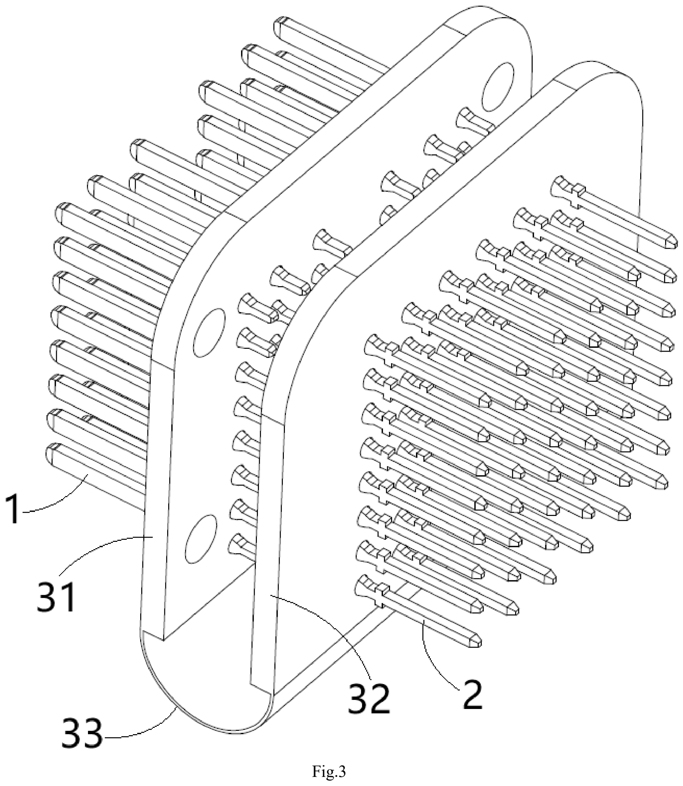

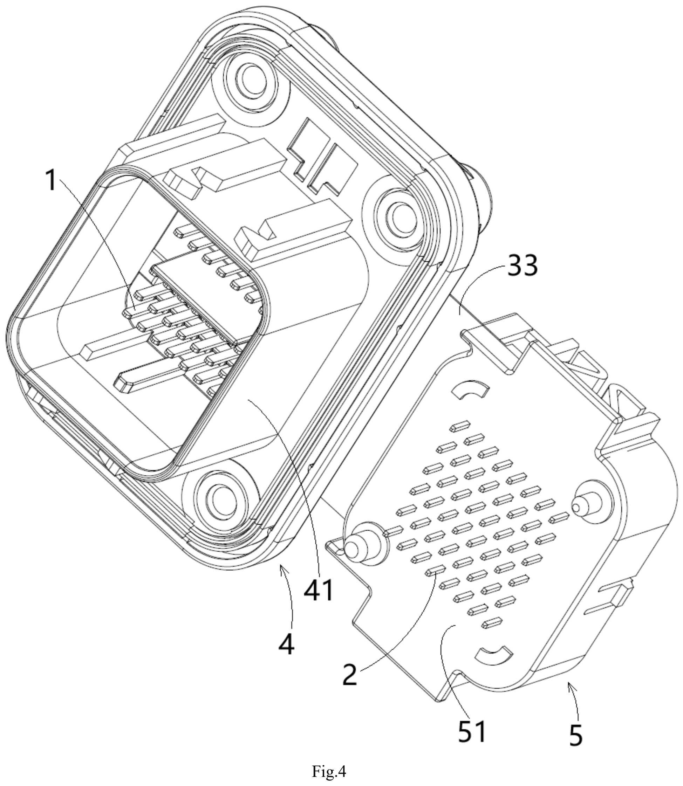

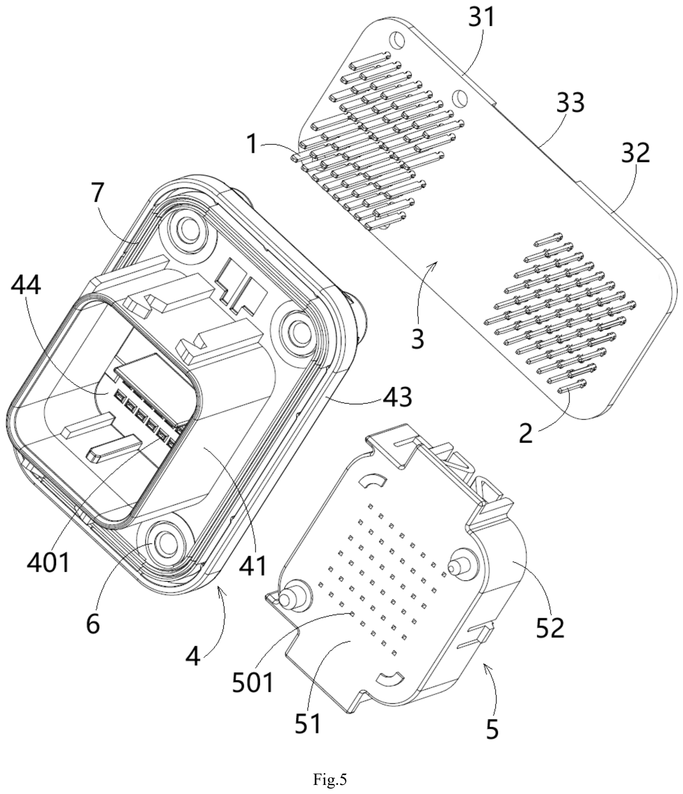

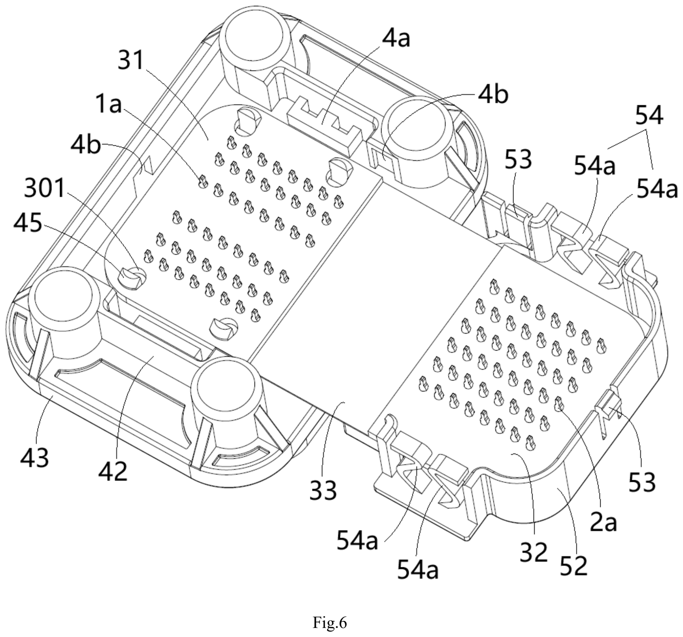

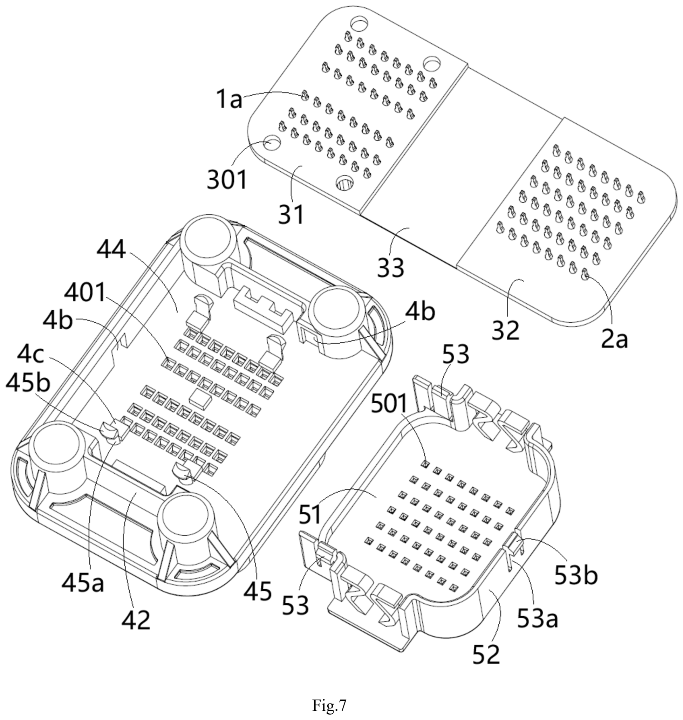

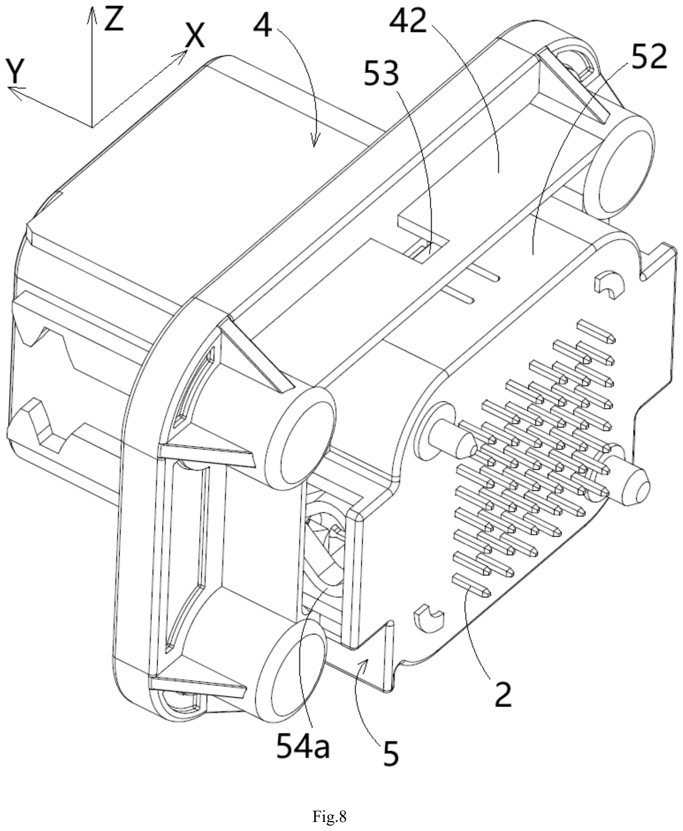

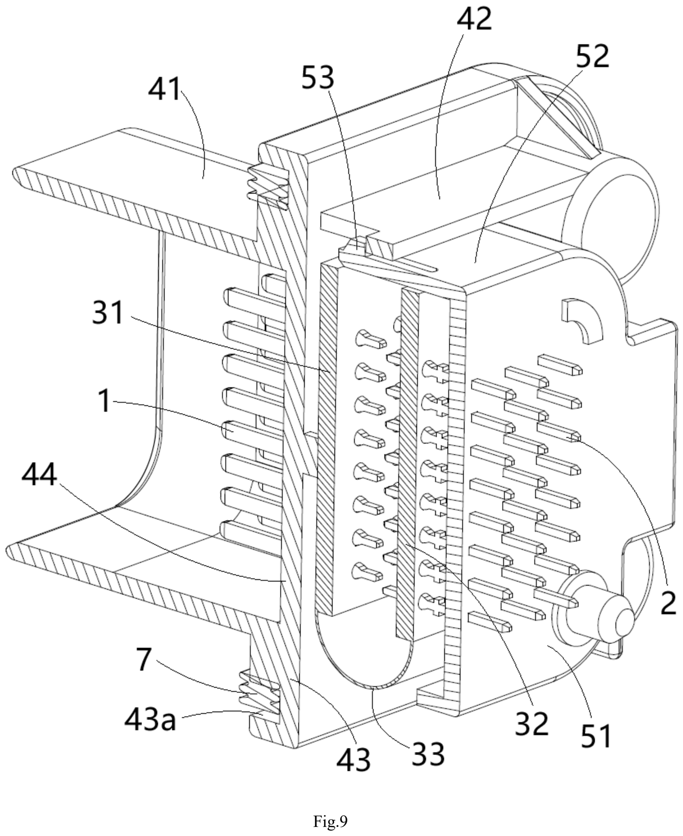

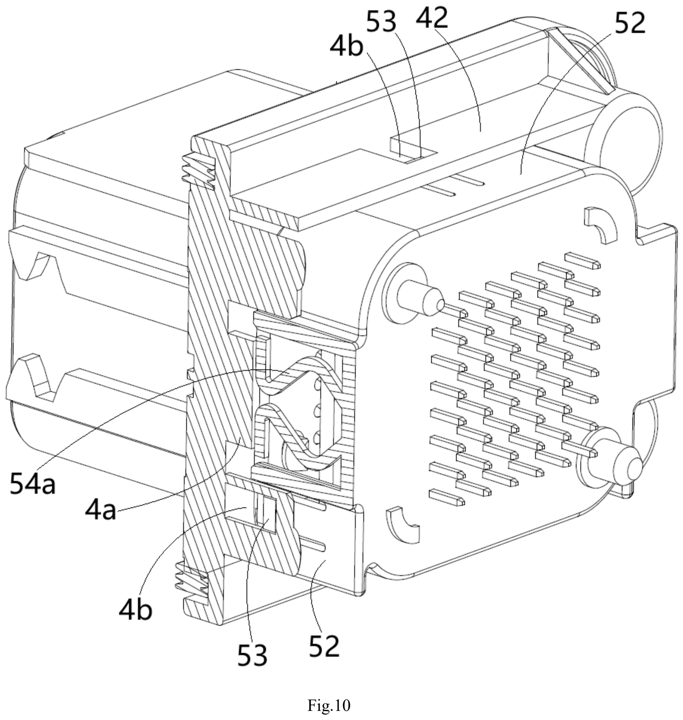

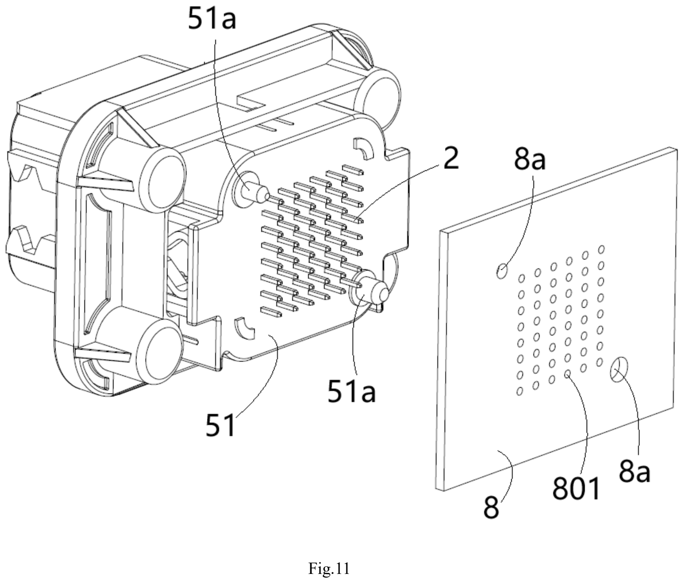

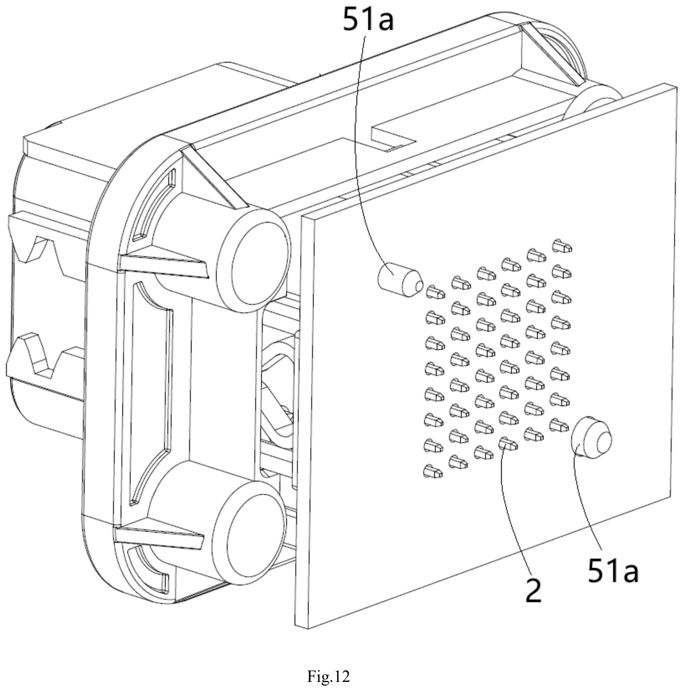

Figure 1 shows an illustrative perspective view of an electrical connection module 100 according to an exemplary embodiment of the present invention; Figure 2 shows an illustrative exploded view of an electrical connection module 100 according to an exemplary embodiment of the present invention; Figure 3 shows an illustrative perspective view of an electrical connection module 100 according to an exemplary embodiment of the present invention, in which the middle flexible board part 33 of the circuit board 3 is bent into a U-shape; Figure 4 shows an illustrative perspective view of a connector according to an exemplary embodiment of the present invention when viewed from one side, where the floatable housing 5 has not yet been installed to the fixed housing 4, and the middle soft board 33 of the circuit board 3 has not been bent; Figure 5 shows an illustrative exploded view of a connector according to an exemplary embodiment of the present invention when viewed from one side, where the floatable housing 5 has not yet been installed to the fixed housing 4, and the middle soft board 33 of the circuit board 3 has not been bent; Figure 6 shows an illustrative perspective view of a connector according to an exemplary embodiment of the present invention when viewed from the other side, where the floatable housing 5 has not yet been installed to the fixed housing 4, and the middle soft board 33 of the circuit board 3 has not been bent; Figure 7 shows an illustrative exploded view of a connector according to an exemplary embodiment of the present invention when viewed from the other side, where the floatable housing 5 has not yet been installed to the fixed housing 4, and the middle soft board 33 of the circuit board 3 has not been bent; Figure 8 shows an illustrative perspective view of a connector according to an exemplary embodiment of the present invention, in which the floatable housing 5 has been installed to the fixed housing 4, and the middle flexible board part 33 of the circuit board 3 has been bent into a U-shape; Figure 9 shows a longitudinal sectional view of a connector according to an exemplary embodiment of the present invention; Figure 10 shows another longitudinal sectional view of a connector according to an exemplary embodiment of the present invention; Figure 11 shows an illustrative exploded view of a connector and an external circuit board 8 according to an exemplary embodiment of the present invention; Figure 12 shows an illustrative assembly view of a connector and an external circuit board 8 according to an exemplary embodiment of the present invention.

As shown in Figures 1 to 8, in an exemplary embodiment of the present invention, an electrical connection module 100 is disclosed. The electrical connection module 100 includes a first terminal 1, a second terminal 2, and a circuit board 3. The circuit board 3 includes a first hard board part 31, a second hard board part 32, and a middle soft board part 33. The first hard board part 31 is formed with a first insertion hole 301. The second hard board part 32 is formed with a second insertion hole 302. The middle soft board part 33 is connected between the first hard board part 31 and the second hard board part 32 and is adapted to be bent. A conductive trace (not shown) is formed on circuit board 3 to electrically connect the first insertion hole 301 and the second insertion hole 302. The first terminal 1 has a first pin 1a that is plugged into the first insertion hole 301. The second terminal 2 has a second pin 2a that is plugged into the second insertion hole 302. The first terminal 1 is suitable for being directly fixed to a fixed housing 4 of a connector or fixed to the fixed housing 4 of the connector through the first hard board part 31, for mating with a mating terminal (not shown) of a mating connector (not shown). The second terminal 2 is suitable for being held to a floatable housing 5 of the connector for electrical connection with an external circuit board 8.

As shown in Figures 1 to 8, in the illustrated embodiment, the first pin 1a is electrically connected to the second pin 2a via the conductive trace on the circuit board 3, and the first hard board part 31 and the second hard board part 32 face each other when the middle soft board part 33 is bent into a U-shape. Please note that the present invention is not limited to the illustrated embodiment. For example, the middle soft plate part 33 can be bent into any suitable shape, such as an L-shape, so that the first hard plate part 31 and the second hard plate part 32 are perpendicular to each other.

As shown in Figures 1 to 8, in the illustrated embodiment, the thickness of the middle soft plate part 33 is smaller than that of the first hard plate part 31 and the second hard plate part 32, so that the middle soft plate part 33 has elasticity and can be bent into a U-shape.

As shown in Figures 1 to 8, in the illustrated embodiment, the first pin 1a of the first terminal 1 is fisheye shaped and press fitted into the first insertion hole 301 in the circuit board 3, and the second pin 2a of the second terminal 2 is fisheye shaped and press fitted into the second insertion hole 302 in the circuit board 3.

As shown in Figures 1 to 8, in the illustrated embodiment, multiple first insertion holes 301 distributed in an array are formed in the first hard board part 31, and multiple second insertion holes 302 distributed in an array are formed in the second hard board part 32. The electrical connection module 100 includes multiple first terminals 1 and multiple second terminals 2. The first pins 1a of the multiple first terminals 1 are respectively plugged into multiple first insertion holes 301, and the second pins 2a of the multiple second terminals 2 are respectively plugged into multiple second insertion holes 302.

As shown in Figures 1 to 8, in the illustrated embodiment, a first locking hole 301 is formed in the first hard plate part 31, which is suitable for engaging with a first elastic buckle 45 on the fixed housing 4, to fix the first hard plate part 31 to the fixed housing 4. However, the present invention is not limited to the illustrated embodiment. For example, a second locking hole (not shown) suitable for engaging with a second elastic buckle (not shown) on the floatable housing 5 may be formed in the second hard plate part 32 to fix the second hard plate part 32 to the floatable housing 5.

As shown in Figures 1 to 8, in another exemplary embodiment of the present invention, a connector is disclosed. The connector includes a fixed housing 4, a floatable housing 5, and the aforementioned electrical connection module 100. The fixed housing 4 is suitable for being fixed to an installation panel (not shown). The floatable housing 5 is mounted on the rear of the fixed housing 4 in a movable manner and can float relative to the fixed housing 4. The middle soft board part 33 of the circuit board 3 is bent, and the first hard board part 31 and the second hard board part 32 of the circuit board 3 face each other in the longitudinal direction Y of the fixed housing 4 or form a certain angle, such as 90 degrees. The first terminal 1 is fixed to the fixed housing 4 for mating with the mating terminal of the mating connector inserted into the fixed housing 4. The floatable housing 5 is suitable for installation on the external circuit board 8, and the second terminal 2 is held to the floatable housing 5 for electrical connection with the external circuit board 8.

As shown in Figures 1 to 8, in the illustrated embodiment, the fixed housing 4 includes a front housing part 41 and a rear housing part 42 that are opposite in its longitudinal direction Y, and a partition wall 44 that separates the inner cavities of the front housing part 41 and the rear housing part 42. A first terminal hole 401 is formed in the partition wall 44. The first hard board part 31 is accommodated in the rear housing part 42 of the fixed housing 4, and the first terminal 1 passes through the first terminal hole 401 in the partition wall 44 and extends into the front housing part 41 to mate with the mating terminal inserted into the front housing part 41.

As shown in Figures 1 to 8, in the illustrated embodiment, the first terminal 1 is interference fit with the first terminal hole 401 to fix the first terminal 1 into the fixed housing 4.

As shown in Figures 1 to 8, in the illustrated embodiment, a first elastic buckle 45 is formed on the partition wall 44 of the fixed housing 4. The first elastic buckle 45 engages with the first locking hole 301 in the first hard plate part 31 to lock the first hard plate part 31 to the fixed housing 4.

As shown in Figures 1 to 8, in the illustrated embodiment, a first support protrusion 4c is formed on the partition wall 44 of the fixed housing 4, which is suitable for resting against one side of the first hard plate part 31. The first elastic buckle 45 includes a first cantilever part 45a and a first protrusion 45b. The first cantilever part 45a is connected to the partition wall 44. The first protrusion 45b is formed on the end of the first cantilever part 45a. The first cantilever part 45a passes through the first locking hole 301, and the first protrusion 45b and the first support protrusion 4c respectively rest on both sides of the first hard plate part 31 to fix the first hard plate part 31 to the partition wall 44.

As shown in Figures 1 to 8, in the illustrated embodiment, the floatable housing 5 includes an end wall 51 facing the second hard plate part 32 and a peripheral wall 52 connected to the periphery of the end wall 51. A second terminal hole 501 is formed in the end wall 51 of the floatable housing 5. The second hard board part 32 is accommodated in the floatable housing 5, and the second terminal 2 extends from the floatable housing 5 through the second terminal hole 501 to be plugged into the insertion hole 801 in the external circuit board 8.

As shown in Figures 1 to 8, in the illustrated embodiment, the second terminal 2 is interference fit with the second terminal hole 501 to fix the second terminal 2 to the floatable housing 5.

However, the present invention is not limited to the illustrated embodiment. For example, a second elastic buckle (not shown) may be formed on the end wall 51 of the floatable housing 5, which is engaged with a second locking hole (not shown) in the second hard plate part 32 to lock the second hard plate part 32 to the floatable housing 5.

As shown in Figure 1 to Figure 8, in the illustrated embodiment, a positioning post 51a is formed on the outer side of the end wall 51 of the floatable housing 5, which is used to mate with the positioning hole 8a in the external circuit board 8 to guide the second terminal 2 to be inserted into the insertion hole 801 on the external circuit board 8.

As shown in Figure 1 to Figure 8, in the illustrated embodiment, two positioning posts 51a are formed on the outer side of the end wall 51 of the floatable housing 5. The two positioning posts 51a have different diameters and are used to respectively fit with two positioning holes 8a of different diameters on the external circuit board 8. This ensures that circuit board 8 is installed in the correct orientation on the floatable housing 5.

As shown in Figures 1 to 8, in the illustrated embodiment, the peripheral wall 52 of the floatable housing 5 is installed into the rear housing part 42 of the fixed housing 4. Multiple elastic buckles 53 are spaced apart on the peripheral wall 52 of the floatable housing 5, and multiple slots 4b are formed on the rear housing part 42 of the fixed housing 4. The multiple elastic buckles 53 are respectively engaged with the multiple slots 4b in a movable manner, so that the floatable housing 5 can float relative to the fixed housing 4 but cannot be separated from it.

As shown in Figures 1 to 8, in the illustrated embodiment, the elastic buckle 53 includes a cantilever 53a and a protrusion 53b. The protrusion 53b is formed on the end of the cantilever 53a. The protrusion 53b of the elastic buckle 53 is engaged into the slot 4b, and the size of the slot 4b is larger than that of the protrusion 53b, to allow the floatable housing 5 to float relative to the fixed housing 4 along the longitudinal direction Y, transverse direction X, and height direction Z of the fixed housing 4.

As shown in Figures 1 to 8, in the illustrated embodiment, multiple elastic structures 54 with spaced distribution are also formed on the peripheral wall 52 of the floatable housing 5, and multiple support platforms 4a are formed on the partition wall 44 of the fixed housing 4. The multiple elastic structures 54 are suitable for respectively resting on the multiple support platforms 4a and can elastically deform along the longitudinal direction Y of the fixed housing 4, so that the floatable housing 5 can float relative to the fixed housing 4 in the longitudinal direction Y.

As shown in Figures 1 to 8, in the illustrated embodiment, the elastic structure 54 includes a pair of curved elastic arms 54a, and the elastic structure 54 is in the shape of an Ω.

As shown in Figures 1 to 8, in the illustrated embodiment, the fixed housing 4 further comprises a flange part 43 located outside it for fixing to the installation panel, and the connector further comprises a nut 6 embedded in the flange part 43 for threaded connection with a screw (not shown), so that the flange part 43 can be fixed to the installation panel by the screw.

As shown in Figures 1 to 8, in the illustrated embodiment, the fixed housing 4 is an integral injection molded part, and the fixed housing 4 is directly injected onto the nut 6, making the fixed housing 4 and nut 6 an integral part.

As shown in Figures 1 to 8, in the illustrated embodiment, the flange part 43 has front and rear sides opposite to each other in the longitudinal direction Y of the fixed housing 4, and a sealing ring mounting groove 43a is formed on the front side of the flange part 43. The nut 6 is located in the area surrounded by the sealing ring mounting groove 43a. The connector also includes a sealing ring 7 installed in the sealing ring installation groove 43a, which is adapted to be compressed between the flange part 43 and the installation panel to achieve sealing between the two.

As shown in Figures 1 to 8, in another exemplary embodiment of the present invention, a connector assembly is also disclosed. The connector assembly includes the aforementioned connector and an external circuit board 8. The external circuit board 8 is electrically connected to the second terminal 2 of the connector. An insertion hole 801 and a positioning hole 8a formed in the external circuit board 8. The second terminal 2 is inserted into the insertion hole 801 in the external circuit board 8, and the positioning post 51a on the floatable housing 5 is inserted into the positioning hole 8a in the external circuit board 8.

As shown in Figures 1 to 8, in the illustrated embodiment, the connector assembly further comprises a mating connector that is mated with the connector.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. An electrical connection module, comprising:
a circuit board (3), including:
a first hard board part (31) which is formed with a first insertion hole (301);
a second hard board part (32) which is formed with a second insertion hole (302); and
a middle soft board part (33) which is connected between the first hard board part (31) and the second hard board part (32) and is adapted to be bent;
a first terminal (1) which has a first pin (1a) that is plugged into the first insertion hole (301); and
a second terminal (2) which has a second pin (2a) inserted into the second insertion hole (302),
wherein a conductive trace is formed on the circuit board (3) to electrically connect the first insertion hole (301) and the second insertion hole (302);
wherein the first terminal (1) is adapted to be fixed to a fixed housing (4) of a connector for mating with a mating terminal of a mating connector, and the second terminal (2) is adapted to be held to a floatable housing (5) of the connector.

2. The electrical connection module according to claim 1,
wherein the first pin (1a) is electrically connected to the second pin (2a) via the conductive trace on the circuit board (3), and the first hard board part (31) and the second hard board part (32) face each other when the middle soft board part (33) is bent into a U-shape.

3. The electrical connection module according to claim 1,
wherein the thickness of the middle soft plate part (33) is smaller than that of the first hard plate part (31) and the second hard plate part (32), so that the middle soft plate part (33) has elasticity and can be bent into a U-shape.

4. The electrical connection module according to claim 1,
wherein the first pin (1a) of the first terminal (1) is fish eye shaped and press fitted into the first insertion hole (301) in the circuit board (3), and the second pin (2a) of the second terminal (2) is fish eye shaped and press fitted into the second insertion hole (302) in the circuit board (3).

5. The electrical connection module according to claim 1,
wherein multiple first insertion holes (301) arranged in an array are formed in the first hard board part (31), and multiple second insertion holes (302) arranged in an array are formed in the second hard board part (32);
wherein the electrical connection module (100) comprises multiple first terminals (1) and multiple second terminals (2), the first pins (1a) of the multiple first terminals (1) are respectively plugged into the multiple first insertion holes (301), and the second pins (2a) of the multiple second terminals (2) are respectively plugged into the multiple second insertion holes (302).

6. The electrical connection module according to claim 1,
wherein a first locking hole (301) adapted to engage with a first elastic buckle (45) on the fixed housing (4) is formed in the first hard plate part (31) to fix the first hard plate part (31) to the fixed housing (4); and/or
wherein a second locking hole suitable for engaging with a second elastic buckle on the floatable housing (5) is formed in the second hard plate part (32) to fix the second hard plate part (32) to the floatable housing (5).

7. A connector, comprising:
a fixed housing (4), suitable for being fixed to an installation panel;
a floatable housing (5) which is mounted on the rear of the fixed housing (4) in a movable manner and can float relative to the fixed housing (4); and
the electrical connection module (100) according to any one of claims 1-6,
wherein the middle soft board part (33) of the circuit board (3) is bent so that the first hard board part (31) and the second hard board part (32) face each other in the longitudinal direction (Y) of the fixed housing (4) or form a certain angle,
wherein the first terminal (1) is fixed to the fixed housing (4) for mating with a mating terminal of a mating connector inserted into the fixed housing (4),
wherein the floatable housing (5) is suitable for installation on an external circuit board (8), and the second terminal (2) is held to the floatable housing (5) for electrical connection with the external circuit board (8).

8. The connector according to claim 7,
wherein the fixed housing (4) comprises a front housing part (41) and a rear housing part (42) that are opposite in its longitudinal direction (Y), and a partition wall (44) that separates the inner cavities of the front housing part (41) and the rear housing part (42), a first terminal hole (401) is formed in the partition wall (44);
wherein the first hard plate part (31) is accommodated in the rear housing part (42) of the fixed housing (4), and the first terminal (1) passes through the first terminal hole (401) in the partition wall (44) and extends into the front housing part (41) to mate with the mating terminal inserted into the front housing part (41).

9. The connector according to claim 8,
wherein the first terminal (1) is interference fit with the first terminal hole (401) to fix the first terminal (1) into the fixed housing (4).

10. The connector according to claim 8,
wherein a first elastic buckle (45) is formed on the partition wall (44) of the fixed housing (4), which engages with the first locking hole (301) in the first hard plate part (31) to lock the first hard plate part (31) to the fixed housing (4),
wherein optionally a first support protrusion (4c) is formed on the partition wall (44) of the fixed housing (4), which is suitable for leaning against one side of the first hard plate part (31);
wherein optionally the first elastic buckle (45) comprises:
a first cantilever part (45a) which is connected to the partition wall (44); and
a first protrusion (45b) which is formed on the end of the first cantilever (5a),
wherein optionally the first cantilever part (45a) passes through the first locking hole (301), and the first protrusion (45b) and the first support protrusion (4c) respectively rest on both sides of the first hard plate part (31) to fix the first hard plate part (31) to the partition wall (44).

11. The connector according to claim 8,
wherein the floatable housing (5) comprises an end wall (51) facing the second hard plate part (32) and a peripheral wall (52) connected to the periphery of the end wall (51), and a second terminal hole (501) is formed in the end wall (51) of the floatable housing (5);
wherein the second hard board part (32) is accommodated in the floatable housing (5), and the second terminal (2) extends from the floatable housing (5) through the second terminal hole (501) to be plugged into an insertion hole (801) in the external circuit board (8),
wherein optionally the second terminal (2) is interference fit with the second terminal hole (501) to fix the second terminal (2) to the floatable housing (5); and/or
wherein optionally a second elastic buckle is formed on the end wall (51) of the floatable housing (5), which engages with the second locking hole in the second hard plate part (32) to lock the second hard plate part (32) to the floatable housing (5); and/or
wherein optionally a positioning post (51a) is formed on the outer side of the end wall (51) of the floatable housing (5), which is used to mate with a positioning hole (8a) in the external circuit board (8) to guide the second terminal (2) to be inserted into the insertion hole (801) in the external circuit board (8),
wherein optionally two positioning posts (51a) with different diameters are formed on the outer side of the end wall (51) of the floatable housing (5), which are used to respectively mate with two positioning holes (8a) with different diameters in the external circuit board (8); and/or
wherein optionally the peripheral wall (52) of the floatable housing (5) is installed into the rear housing part (42) of the fixed housing (4), and multiple elastic buckles (53) distributed at intervals are formed on the peripheral wall (52) of the floatable housing (5); multiple slots (4b) are formed on the rear housing part (42) of the fixed housing (4), and the multiple elastic buckles (53) are respectively engaged with the multiple slots (4b) in a movable manner, so that the floatable housing (5) can float relative to the fixed housing (4) but cannot be separated from the fixed housing (4),
wherein optionally the elastic buckle (53) comprises:
a cantilever (53a); and
a protrusion (53b) which is formed at the end of the cantilever (53a),
wherein the protrusion (53b) of the elastic buckle (53) is engaged into the slot (4b) and the size of the slot (4b) is larger than the protrusion (53b) to allow the floatable housing (5) to float relative to the fixed housing (4) along the longitudinal direction (Y), transverse direction (X), and height direction (Z) of the fixed housing (4), and/or
wherein optionally multiple elastic structures (54) spaced apart are also formed on the peripheral wall (52) of the floatable housing (5), and multiple support platforms (4a) are formed on the partition wall (44) of the fixed housing (4); the multiple elastic structures (54) are adapted to respectively rest on the multiple support platforms (4a) and can elastically deform along the longitudinal direction (Y) of the fixed housing (4), so that the floatable housing (5) can float relative to the fixed housing (4) in the longitudinal direction (Y),
wherein optionally the elastic structure (54) comprises a pair of curved elastic arms (54a), and the elastic structure (54) is in the shape of an Ω.

12. The connector according to claim 8,
wherein the fixed housing (4) further comprises a flange part (43) located outside it for fixing to an installation panel, and the connector further comprises a nut (6) embedded in the flange part (43) for threaded connection with a screw, so that the flange part (43) can be fixed to the installation panel through the screw.

13. The connector according to claim 12,
wherein the fixed housing (4) is an integral injection molded part, and the fixed housing (4) is directly injected onto the nut (6), making the fixed housing (4) and the nut (6) an integrated piece; and/or
wherein the flange part (43) has front and rear sides opposite to each other in the longitudinal direction (Y) of the fixed housing (4), and a sealing ring installation groove (43a) is formed on the front side of the flange part (43), the nut (6) is located in the area surrounded by the sealing ring installation groove (43a);
wherein the connector further comprises a sealing ring (7) installed into the sealing ring installation groove (4c), wherein the sealing ring (7) is adapted to be compressed between the flange part (43) and the installation panel to achieve sealing between the two.

14. A connector assembly, comprising:
the connector according to any one of claims 7-13; and
an external circuit board (8) electrically connected to the second terminal (2) of the connector,
wherein an insertion hole (801) and a positioning hole (8a) are formed in the external circuit board (8), the second terminal (2) is inserted into the insertion hole (801) in the external circuit board (8), and the positioning post (51a) on the floatable housing (5) is inserted into the positioning hole (8a) in the external circuit board (8).

15. The connector assembly according to claim 14, further comprising:
a mating connector which is mated with the connector.
